# EUROPEAN PATENT SPECIFICATION

(11) **EP 3 657 592 B1**
(45) Date of publication and mention of the grant of the patent: **20.04.2022**
(21) Application number: 18207513.5
(22) Date of filing: 21.11.2018
(51) Int. Cl.: H01M 10/42, H01M 50/20, H01M 50/572

(54) **CONTROL UNIT FOR A BATTERY MODULE OR SYSTEM**
STEUEREINHEIT FÜR EIN BATTERIEMODUL ODER -SYSTEM
UNITÉ DE COMMANDE POUR UN MODULE OU UN SYSTÈME DE BATTERIE

(43) Date of publication of application: 27.05.2020
(73) Proprietor: Samsung SDI Co., Ltd., Gyeonggi-do 17084 (KR)
(72) Inventor: Haindl, Michael, 8230 Hartberg (AT); Hofer, Maximilian, 8230 Hartberg (AT)
(74) Representative: Gulde & Partner

(56) References cited:
- EP-A1- 3 331 121
- JP-A- H03 235 399
- US-A1- 2007 229 026
- US-A1- 2010 019 730

## Description

### Field of the Invention

The present invention relates to a control unit for a battery module or battery system, to a battery module or battery system comprising such a control unit and a method for operating such battery module or battery system.

### Technological Background

A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose. Lithium-ion (and similar lithium polymer) batteries, widely known via their use in laptops and consumer electronics, dominate the most recent group of electric vehicles in development.

Rechargeable batteries may be used as a battery module formed of a plurality of unit battery cells coupled in series and/or in parallel so as to provide a high energy density, e.g. for motor driving of a hybrid vehicle. That is, the battery module is formed by interconnecting the electrode terminals of the plurality of unit battery cells depending on a required amount of power and in order to realize a high-power rechargeable battery, e.g. for an electric vehicle. One or more such battery modules are mechanically and electrically integrated, equipped with a thermal management system and a battery management system (BMS) and set up for communication with one or more electrical consumers in order to form a battery system.

For meeting the dynamic power demands of various electrical consumers connected to such battery system a static control of battery power output and charging is not sufficient. Thus, steady exchange of information between the battery system and the controllers of the electrical consumers is required. This information includes the battery systems actual state of charge (SoC), potential electrical performance, charging ability and internal resistance as well as actual or predicted power demands or surpluses of the consumers. Battery systems usually comprise a battery management system (BMS), battery system manager (BSM), or battery management unit (BMU) for processing this information. The BMS/BSM/BMU may communicate to the controllers of the various electrical consumers via a suitable communication bus, e.g. a SPI or CAN interface. The BMS/BSM/BMU may further communicate with each of the battery submodules, e.g. with a cell supervision circuit (CSC) of each battery submodule. Therein, the CSC may be connected to a cell connection and sensing unit (CCU) that interconnects the battery cells of the battery submodule. Hence, the BMS/BSM/BMU is provided for managing the battery pack, such as by protecting the battery from operating outside its safe operating area, monitoring its state, calculating secondary data, reporting that data, controlling its environment, authenticating it and/or balancing it.

Battery systems usually comprise a battery housing serving as enclosure to seal the battery system against the environment and providing protection to the battery system from environmental impacts and to protect the environment from any hazards, such as e.g., toxic fumes, fire, electric arcing, etc. in case of battery failure. Housed battery systems are usually mounted as a whole into their application environment, e.g. an electric vehicle, wherein all essential parts of the battery system, i.e. the cells, electric interconnectors, and the electronics, are situated inside the battery housing. Thus, the replacement or analysis of system parts, e.g. of a battery cell or control electronics, requires the removal of its housing.

Current battery systems can be opened and the technology of the battery system can be analyzed using reverse engineering. Also, the hardware and/or the software of the battery system can be manipulated in order to alter the operation state of the battery system, e.g. in order to increase the performance and/or to circumvent safety measures of the battery system. Next to posing a serious thread to the users, such manipulation may decrease the lifetime of the battery system and the battery may lose energy and power faster compared to normal use. Hence, next to dangerous failures unjustified warranty cases may occur based on the reduced lifetime. Therein, if a manipulation is reverted to the original version, it might not even be possible to detect the manipulation of the battery system.

It is thus an object of the present invention to overcome or reduce at least some of the drawbacks of the prior art and to provide a battery system, which enables detection and/or prevention of unauthorized misuse, analysis and/or manipulation of the battery system.

### Summary of Invention

One or more of the drawbacks of the prior art could be avoided or at least reduced by means of the present invention. In particular, a control unit for a battery module or battery system according to claim 1 is provided, particularly for a battery module or battery system with a plurality of battery cells fully enclosed in a housing. Therein, the control unit of the present invention comprises a control module that is configured for performing at least control function with respect to the at least one battery cell, such as e.g., a BMS, BSM, BMU, CSC, or the like. The control unit further comprises an access detection circuit that is connected to the control module and that comprises a light sensitive element disposed within said housing. The light sensitive element is configured to detect light intensity within the housing and incident on the light sensitive element. Particularly, the light sensitive element is configured to detect an intensity of light, particularly visible light, within said housing. The access detection circuit of the present invention is configured to operate the light sensitive element and particularly to output an access detection signal in response to detecting, via the light sensitive element, a light intensity within said housing that exceeds a predefined threshold, particularly a predefined intensity threshold. Further, the control unit of the invention is configured to alter a state of the control module in response to the access detection signal. Therein, the state of the control module can be altered directly or indirectly in response to receiving the access detection signal emitted by the access detection circuit.

For a battery module or system having an enclosed housing it can be usually assumed that no light will be inside the battery module or system during a normal use of the battery module or system. Hence, an opening, particularly an unauthorized opening, of the battery module or system housing can be detected based on that light, particularly visible light, is detected within the housing. In order to avoid false positives, only light intensity that exceeds a predefined threshold causes the output of an access detection signal. Therein, the access detection signal is representative of an opening of the battery module or system housing. Thus, outputting the access detection signal allows to react to such opening of the housing by altering the state of the control module in a specific way. In other words, the present invention allows detecting an attempt to manipulate a battery module or system by detecting an opening of its housing and outputting an access detection signal in response thereto. The access detection signal allows for initiating appropriate measures in response thereto.

In the context of the present invention, the control module can be one of a BMS, BSM, BMU, CSC or the like and may further be an electronic circuit that is configured for controlling an individual battery cell. Usually a control module comprises one or more integrated circuits (ICs) that are mounted on a suitable circuit carrier, e.g. a printed circuit board (PCB). A control module according to the invention may be power supplied by at least one battery cell that is controlled by the control module unit, e.g. as a part of the battery system or the battery module that is controlled by the control module. Alternatively, the control module is power supplied by at least one additional battery cell that is not part of the controlled batteries.

According to the present invention, the smooth or optimal function of a battery cell depends on the control module performing at least one control function with respect to at least one battery cell. The control functions may comprise the measurement of cell voltages, cell currents, cell resistances or cell capacities and, for a plurality of battery cells, may further comprise the active or passive balancing of cell voltages or cell currents. Further, the control module may be configured to communicate with other control units of the battery module or system or of an electric vehicle. Suitable circuit designs for performing one or more of these functions are known to the skilled person. In order to perform the at least one control function, the control unit and the control module must be supplied with an operation voltage.

As the control module performs at least one control function with respect to at least one battery cell of the battery module or system, the altering of a state of the control module may also cause altering of a state of the battery module or system. However, the altering of the state of the control module may also refer to altering the state of a memory of the control module, i.e. by storing therein information that are representative of the opening of said housing of the battery module or system. Hence, preferably the control unit of the invention is further configured to alter the state of the hardware of the control module and/or the state of software of the control module in response to the access detection signal. Therein, altering a state of a software includes altering an information in a memory of the control module. Hence, various measures can be initiated in response to the access detection signal and the function of the control unit of the invention can be applied to the specific application case.

The housing of the battery module or system can be made of a variety of different materials.

Preferably, the material of the housing blocks light in a wavelength range that is detected by the light sensitive element such that no signal is emitted by the light sensitive element while the housing of the battery module or system remains closed. Particularly, metal, such as e.g., aluminum, is used to further achieve a mechanical rigid design to protect the inner parts from environmental impacts and to protect the environment from any hazards in case of battery failure. Further preferred, the housing consists at least out of two shells that are connected to each other by screws, adhesive or welding or the like. Preferably, operation of the battery system or module does not require any opening or access to the inner of the housing, such that any signal emitted by the light sensitive element indicates an unintended operation of the battery module or system. Thus, the predefined threshold for a light intensity, above which the access detection signal is emitted, can be set rather low.

In a preferred embodiment of the present invention, the control unit is further configured to store the access detection signal in a memory of the control unit. In other words, the output of the access detection signal itself is an event that is stored in a memory, preferably together with a time and/or a date of the emission of the access detection signal. Preferably, the access detection signal is stored in a memory of the control module, the state of which is thus altered. In this preferred embodiment, the attempt of opening the battery module or system housing case can thus be detected afterwards, e.g., in and from an authorized repair station.

In a further preferred embodiment, the control unit of the invention is further configured to disable at least one function of the control module in response to the access detection signal. As set forth above, the at least one control function is required for smooth or optimal function of the battery cells of the battery module or system. According to this embodiment, the at least control function is preferably required for any operation or function of the battery cells. Hence, by disabling the at least one function of the control module, the operation of the battery module or system is stopped in response to detecting an opening of the housing. Thus, any unwanted manipulation on or reverse engineering of the battery module or system can be avoided. This embodiment further increases safety for a user of the battery module or system, as high voltages and currents are ceased in case the housing is opened.

Further preferred, the control unit is configured to allow the enablement of the at least one function of the control module by an original equipment manufacturer, OEM. In other words, the altering of the state of the control module, either on hardware or software level, is reversible. Exemplarily, a bit set in response to the access detection signal and preventing a normal function of the battery module may be deleted by the OEM. Additionally or alternatively, a component destroyed, e.g., a fuse burned, in response to the access detection signal, can be replaced by the OEM. For larger HV traction batteries it has become more common that inner parts, such as e.g., battery cells, electric interconnectors, or electronics, can be replaced in a workshop of the OEM in order to prolong the lifetime of the battery and/or in the case of malfunctions. This embodiment advantageously allows for providing such services of an OEM and allows for refurbishing a battery module or system that has been shut down in response to an unauthorized opening of the battery housing.

In a further preferred embodiment, the light sensitive element is configured to output a light signal with a strength that depends on light, which is incident on the light sensitive element within the housing. Alternatively, the light sensitive element is configured to output a light signal only if the incident light intensity exceeds a predefined threshold. In the latter case, the light signal equals the access detection signal. Further preferred, the light sensitive element comprises at least one of a light dependent resistor, a photo diode, and a photovoltaic element. Each of these light sensitive elements allows for specific embodiments having specific advantages as described in more detail below.

If the light sensitive element is configured to output a light signal with a strength that depends on light incident thereon, the control unit of the invention preferably further comprises a detection element that is configured to receive such light signal, and to determine whether the light intensity in the housing exceeds a predefined intensity threshold based on the light signal. Therein, if the light signal is a voltage, the detection element may be configured to detect whether the light signal exceeds a predefined voltage. If the light signal is a current, the detection element may be configured to detect whether the light signal exceeds a predefined current. According to this embodiment, the detection element is further configured to output the access detection signal, if it is determined that the light intensity in the housing exceeds the predefined intensity threshold. According to this embodiment, a common light sensitive element can be mounted to the battery module or system housing, wherein the determination of whether an opening of the housing occurred is performed by the detection element of the control unit.

In a further preferred embodiment, the control unit further comprises a state setting element that is configured to receive either the light signal emitted by the light sensitive element or the access detection signal emitted by the detection element. The state setting element is further configured to alter the state of the control module based on the received signal, i.e. depending on whether or not the access detection signal is received or depending of a value (intensity/height) of the detected light signal. In other words, the state setting element is configured to alter the state of the control module if the received signal is indicative of an opening of the battery module or system housing.

In a particularly preferred embodiment of the invention, the control unit further comprises a power input that is configured to receive an operation voltage of the control unit. In other words, an operation voltage of the control unit and its constituents, e.g. the control module, is supplied to the power input. Particularly, the power input is configured to provide the operation voltage to the control module. According to this embodiment, the state setting element comprises a switching element that is disposed between the power input and the control module of the control unit. Particularly preferred, the state setting element is configured to set the switching element non-conductive in response to receiving the access detection signal. Thus, the power input is cut from the control module and thus the operation voltage of the control module is not longer supplied thereto. Hence, the at least one control function with respect to at least one battery cell of the battery module or system is ceased. Thus, the battery module or system is shut down in response to an opening of its housing.

According to an alternatively preferred embodiment, the state setting element of the control unit comprises at least one fuse that is configured to be set non-conductive, if the received signal exceeds a predefined threshold. In other words, if the state setting element receives the light signal, the fuse is configured to be set non-conductive if the light signal exceeds a predefined threshold. Further, if the state setting element is configured to receive the access detection signal, the fuse is preferably configured to be set non-conductive in response to receiving the access detection signal and/or if the access detection signal exceeds a predefined threshold. Particularly preferred, the at least one fuse is at least one fuse bit that is set-non conductive by fusing, i.e., melting. By using multiple fuses, e.g. fuse bits, also information, e.g. the number of multiple openings, can be stored in the control unit.

In a particularly preferred embodiment, the energy required to set the at least one fuse non-conductive is provided by or via the light sensitive element. Preferably, the light sensitive element is a photovoltaic cell and the current/voltage output by the photovoltaic cell in response to a light intensity exceeding a predefined threshold is suitable for burning the fuse. Alternatively, the light sensitive element is a light dependent resistor, LDR, that is interconnected between a voltage or power source and the at least one fuse. In response to an incident light intensity exceeding a predefined threshold, the resistance of the LDR drops so far that a current passing the LDR is sufficient to burn the at least one fuse downstream the LDR.

Another aspect of the present invention relates to a battery module or battery system, comprising a plurality of battery cells that is fully enclosed by a housing and that further comprises a control unit according to the present invention as described above. The control unit is preferably at least part of at least one of a battery management system (BMS), a Battery System Manager (BSM), a battery monitoring unit (BMU) or a cell supervision circuit (CSC) of the battery system. The battery system may further comprise a cooling system. Another aspect of the present invention relates to a method for operating a battery module or a battery system according to the invention as described above. The method is defined in the independent claim 10. Therein, the method of the invention comprises at least the steps of performing, via the control module, at least one control function with respect to at least one battery cell. Therein, the performing of the at least one control function is required for smooth, optimal or any operation of the at least one battery cell and thus the battery module or system. The method of the present invention further comprises the step of detecting, via the light sensitive element, a light within the housing that is incident on the light sensitive element. Therein, the detection may be provided by outputting a light signal (access detection signal) only if the incident light intensity exceeds a predefined threshold or by outputting a light signal proportional to an intensity of incident light to a detection element that determines whether or not it corresponds to an intensity above said threshold. The method further comprises the step of outputting, via the access detection circuit, an access detection signal in response to detecting that the light intensity within the housing exceeds the predefined threshold. Further, in the method of the present invention in response to the access detection signal a state of the control module is altered, e.g. by setting a switching element or a fuse non-conductive.

In a preferred embodiment of the method of the invention, altering the state of the control module preferably comprises the step of disabling at least one function of the control module in response to the access detection signal. The method of this embodiment further comprises the step of enabling the at least one control function of the control module, i.e., the control function which has been disabled before, by an original equipment manufacturer, OEM. Thus, the OEM can advantageously refurbish battery modules or systems that were inactivated in response to an opening of the housing and provide services to battery modules or systems without altering an operation state of a control module thereof in a persistent manner.

Further aspects of the present invention could be learned from the dependent claims or the following description.

### Brief Description of the Drawings

Features will become apparent to those of ordinary skill in the art by describing in detail exemplary embodiments with reference to the attached drawings in which:
Fig. 1 illustrates a schematic perspective view of a battery module; and
Fig. 2 schematically illustrates the assembly of battery system according to an embodiment;
Fig. 3 schematically illustrates a control unit according to an embodiment;
Fig. 4 schematically illustrates an access detection circuit according to an embodiment not belonging to the present invention; and
Fig. 5 schematically illustrates an access detection circuit according to another embodiment.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present invention, however, may be embodied in various different forms, and should not be construed as being limited to the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described. Unless otherwise noted, like reference numerals denote like elements throughout the attached drawings and the written description, and thus, descriptions thereof will not be repeated. In the drawings, the relative sizes of elements, layers, and regions may be exaggerated for clarity.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention. In the following description, the terms of a singular form may include plural forms unless the context clearly indicates otherwise.

It will be further understood that the terms "include," "comprise," "including," or "comprising" specify a property, a region, a fixed number, a step, a process, an element, and a combination thereof but do not exclude other properties, regions, fixed numbers, steps, processes, elements, and combinations thereof. It will also be understood that when a region or an element is referred to as being "above" or "on" another region or element, it can be directly on the other region or element, or intervening regions or elements may be present.

The terminology used herein is for the purpose of describing particular embodiments only and is not intended to be limiting of the present invention. As used herein, the term "and/or" includes any and all combinations of one or more of the associated listed items. Further, the use of "may" when describing embodiments of the present invention refers to "one or more embodiments of the invention. As used herein, the singular forms "a," "an," and "the" are intended to include the plural forms as well, unless the context clearly indicates otherwise.

As used herein, the term "substantially," "about," and similar terms are used as terms of approximation and not as terms of degree, and are intended to account for the inherent deviations in measured or calculated values that would be recognized by those of ordinary skill in the art. Further, the term "substantially" used in combination with a feature that can be expressed as numeric value denotes a range of +/- 5% of the value centered on the value.

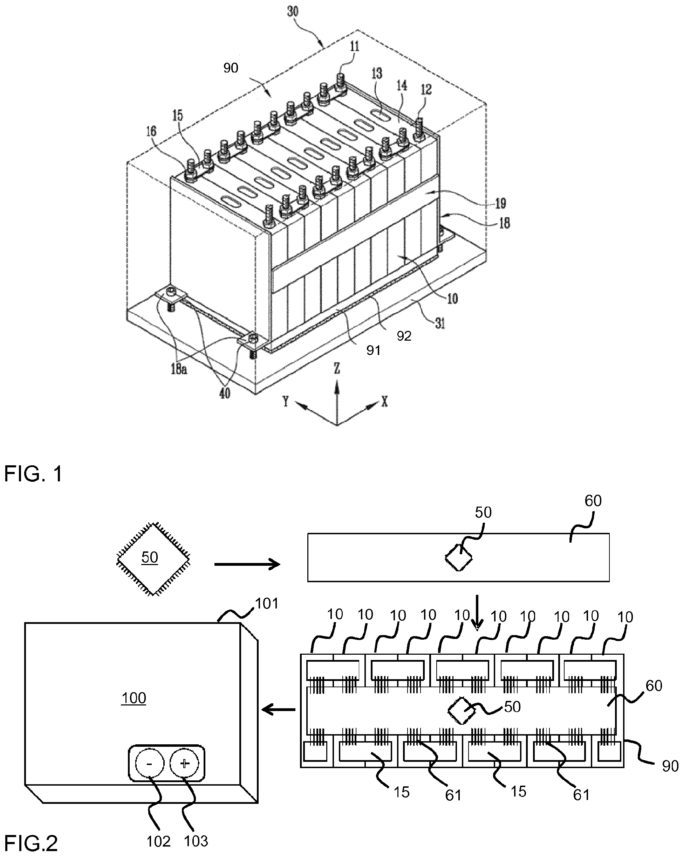

Figure 1 illustrates a schematic perspective view of a conventional battery module 90 that includes a plurality of battery cells 10 aligned in one direction and a heat exchange member 91 provided adjacent to a bottom surface of the plurality of battery cells 10. A pair of end plates 18 is provided to face wide surfaces of the battery cells 10 at the outside of the battery cells 10, and a connection plate 19 is configured to connect the pair of end plates 18 to each other thereby fixing the plurality of battery cells 10 together. Fastening portions 18a on both sides of the battery module 90 are fastened to a support plate 31 by bolts 40. The support plate 31 is part of a housing 30 that is fully enclosing battery module 90 and its constituents, i.e., the battery cells 10, electric interconnectors 15 and control electronics.

Further, each battery cell 10 is a prismatic (or rectangular) cell, the wide flat surfaces of the battery cells 10 being stacked together to form the battery module 90. Further, each battery cell 10 includes a battery case configured for accommodation of an electrode assembly and an electrolyte. The battery case is hermetically sealed by a cap assembly 14 that is provided with positive and negative electrode terminals 11 and 12 having different polarities, and a vent 13. The vent 13 is a safety means of the battery cell 10, which acts as a passage through which gas generated in the battery cell 10 is exhausted to the outside of the battery cell 10. The positive and negative electrode terminals 11 and 12 of neighboring battery cells 10 are electrically connected through a bus bar 15, and the bus bar 15 may be fixed by a nut 16 or the like. Hence, the battery module 90 may be used as power source unit by electrically connecting the plurality of battery cells 10 as one bundle.

Generally, the battery cells 10 generate heat while being charged/discharged. The generated heat is accumulated in the battery cells 10, thereby accelerating the deterioration of the battery cells 10. Therefore, the battery module 90 further includes a heat exchange member 91, which is provided adjacent to the bottom surface of the battery cells 10 so as to cool down the battery cells 10. In addition, an elastic member 92 made of an elastic materials may be interposed between the support plate 31 and the heat exchange member 91.

Figure 2 schematically illustrates a workflow for manufacturing a battery system 100 comprising the battery module 90 of Figure 1 and a control unit 50 of to the present invention.

As shown in Figure 2, a first step is the production of a cell supervision circuit (CSC) as a control unit 50 according to the invention. The control unit 50 is produced by a semiconductor chip manufacturer, wherein the production process comprises at least the steps of FEOL, BEOL, dicing and packaging. Several testing procedures are performed on the control unit 50, usually before wafer dicing or packaging. However, the packaged control unit 50 can be object to testing as well. In the testing procedures several electronic functions of the control unit 50 are tested, particularly with respect to at least one control function of the control unit 50. The testing might comprises voltage measurement tests, wherein predetermined voltages are measured with the control unit 50. The results of such measurement tests are then compared to the predetermined voltages and calibration data is derived from such comparison and saved to the control unit 50. Additionally, stress tests are performed on the control unit 50 by repeatedly performing some of its electronic functions.

In a second step of the workflow shown in Figure 2, the control unit 50 is assembled on a suitable circuit carrier 60, such as a printed circuit board (PCB) or flexible circuit board. Exemplarily, the control unit 50 is flip-chip mounted to the circuit carrier 60. Electric connections between the control unit 50 and the circuit carrier 60 are established by soldering, which may decrease the analogue performance of the control unit 50.

In a third step of the workflow of Figure 2, the circuit carrier 60 comprising the control unit 50 is mounted to the battery module 90 of Figure 1, comprising the plurality of secondary battery cells 10. Therein, the terminals (not shown) of the battery cells 10 are connected to the circuit carrier 60 via wire bonds 61. The battery cells 10 are thus connected to the control unit 50 and an operation voltage is supplied to the control unit 50 by at least one battery cell 10. Preferably, the control unit 50 is activated by initially providing the operation voltage to the control unit 50 by at least one battery cell 10 or an additional battery configured for supplying the control unit 50 and provided on the circuit carrier 60. The control unit 50 may be supplied by the at least one battery cell 10 or the additional battery during the entire service life of the battery system 100. Further, the battery cells 10 may be interconnected via bus bars 15.

In a fourth step of the production process of the battery system 100, a plurality of battery modules 90 are connected to each other to form the battery system 100. Therein, the module terminals (not shown) of the battery modules 90 are connected to each other using system bus bars (not shown). Further the CSCs 50 of the battery modules 90 are connected to each other as well as to a BMS (not shown) using a suitable communication bus, e.g. SPI or CAN. The plurality of interconnected battery modules 90 is placed in a system housing 101 and a cooling circuit may be set up for cooling the battery modules 90. In the battery system 100, the battery module housing 30 as shown in Figure 1 might be omitted. The plurality of battery modules 90 provides a system voltage and system current via the system terminals 102, 103.

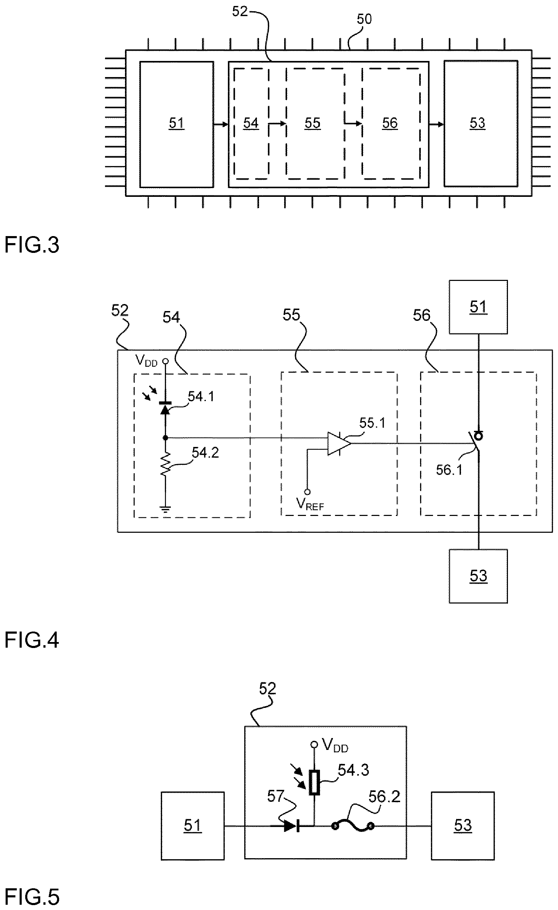

Figure 3 schematically illustrates a control unit 50 for a battery module 90 according to Figure 1, e.g. a CSC, or for battery system 100 according to Figure 2, e.g. a BSM. The control unit 50 comprises a power input 51 that is configured to be connected to at least one voltage supply for receiving an operation voltage of the control module 53. Therein, the voltage supply may be provided by at least one battery cell 10 of the battery module 90 or battery system 100 or by an additional battery provided specifically for supplying the control module 53. The power input 51 may comprises a contact pad that is configured to be electrically connected to at least one battery cell 10, e.g. via at least one wire bond or the like.

The power input 51 is electrically connected to a control module 53 via an access detection circuit 52. The control module 53 is configured to perform at least one control function with respect to at least one battery cell 10. The control functions may comprise the measurement of cell voltages, cell currents, cell resistances or cell capacities and, for a plurality of battery cells 10, may further comprise the active or passive balancing of cell voltages or cell currents. The control module 53 may comprise at least one contact pad (not shown) for establishing an electronic contact to at least one battery cell 10. The electronic contact may be established via a wire bond 61 that may be different from the wire bond for connecting at least one battery cell 10 with the power input 51 of the control module 53.

The access detection circuit 52 shown in Figure 3 comprises a light sensitive element 54, particularly a light sensitive element, that is configured to detect light within the housing 30 of battery module 90 (or housing 101 of battery system 100). The light sensitive element 54 is connected to a detection element 55 that is configured to receive a light signal output from the light sensitive element 54 and that is representative of the detected light. The detection element 55 is further configured to output an access detection signal, if the light signal received from the light sensitive element 54 is indicative of light intensity within the housing 30 that exceeds a predefined threshold. The output access detection signal is received by a state setting element 56 that is configured to alter a state of the control module 53 in response to receiving the access detection system of the detection element 55.

Figure 4 shows an embodiment of an access detection circuit 52 not belonging to the present invention.

Therein, the light sensitive element 54 comprises a voltage divider with an output node interconnected between an operation voltage V_{DD} and ground. A photodiode 54.1 is interconnected between the output node and the supply node V_{DD} and a resistor 54.2 is interconnected between the output node and ground. A voltage drop over photodiode 54.1 depends on the light incident thereto. Hence, a voltage at the output node of the voltage divider depends on the light incident on the photodiode 54.1 and forms a light signal.

The light signal is transmitted to comparator 55.1 of a detection element 55, particularly to a non-inverting input of comparator 55.1. A reference signal V_{REF} is input to the inverting input of the comparator 55.1 that further receives a supply voltage that may be derived from one or more of V_{DD}, V_{REF}, and ground. The comparator outputs a high signal, e.g., "1", if the voltage of the light signal exceeds V_{REF} and outputs a low signal, e.g., "0", if V_{REF} exceeds the voltage of the light signal. Further, the reference voltage V_{REF} is indicative of a predefined intensity threshold of light within the housing 30. In other words, the output of comparator depends on whether the light intensity detected by the photodiode 54.1 within the housing exceeds the predefined intensity threshold, wherein the high output, e.g., "1", of the comparator 55.1 might be considered the access detection signal of the invention.

The output of the comparator 55.1 is transmitted to a switching element 56.1 of state setting element 56 that is interconnected between a power input 51 and a control module 53 of a control unit 50 as described above. Therein, the conductivity of the switching element 56.1 is set in dependence of the output of the comparator 55.1. Exemplarily, the switching element 56.1 is a bipolar p-channel PNP transistor that is set conductive if a low signal is applied to its basis and that is set non-conductive if a high signal is applied to its basis. Alternatively, switching element 56.1 is a MOSFET transistor with similar characteristics. Hence, switching element 56.1 is set non-conductive if the voltage of the light signal exceeds V_{REF} and thus the control module 53 is not longer supplied by power input 51 and cannot longer perform the at least one control function with respect to the at least one battery cell 10.

Figure 5 shows an alternative embodiment of an access detection circuit according to the invention. Therein, the access detection circuit 52 is again interconnected between a power input 51 and a control module 53 of a control unit as described above. A conductive path is formed between the power input 51 and the control module 53 and a diode 57 and a fuse 56.2 are disposed in the conducting path. Therein, the anode of the diode 57 is connected to the power input 51 and the cathode of the diode 57 is connected to the fuse 56.2. Further, the fuse 56.2 forms a state setting element 56 as described above. A voltage V_{DD} is connected to the conducting path via light detection resistor 54.3 and in between the diode 57 and fuse 56.2. The voltage of the LDR 54.3 decreases with increasing intensity of the incident light. If the incident light intensity exceeds a predefined intensity threshold, the ohmic resistance of LDR 54.3 and thus a voltage drop over LDR 54.3 becomes low. Thus, a current passing the LDR 54.3 and generated by the remaining voltage of V_{DD} in fuse 56.2 is sufficient to burn the fuse 56.2. Hence, the control module 53 is cut from the power input 51 and cannot longer perform the at least one control function with respect to the at least one battery cell 10. Instead of using LDR 54.3 interconnected between V_{DD} and a node between diode 57 and fuse 56.2, a photovoltaic cell (not shown) can be connected to the node between diode 57 and fuse 56.2. Therein, a current provided to the fuse 56.2 from the photovoltaic cell is sufficient to burn fuse 56.2, if a light incident on the photovoltaic cell exceeds a predefined intensity threshold. Hence, the voltage V_{DD} must mot be provided in this example. In both embodiments described here, the current supplied from power input 51 to the control module 53 while supplying control module 53 is not sufficient for burning the fuse 56.2.

The electronic or electric devices and/or any other relevant devices or components according to embodiments of the present invention described herein may be implemented utilizing any suitable hardware, firmware, such as e.g. an application-specific integrated circuit, ASIC, software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the exemplary embodiments of the present invention.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly defined so.

### Reference signs

- 10: battery cell
- 11: positive electrode terminal
- 12: negative electrode terminal
- 13: vent
- 14: cap assembly
- 15: busbar
- 16: nut
- 18: end plates
- 18a: fastening portions
- 19: connection plate
- 30: battery module housing
- 31: support plate
- 40: bolts
- 50: control unit
- 51: power input
- 52: access detection circuit
- 53: control module
- 54: light sensitive element
- 54.1: photodiode
- 54.2: resistor
- 54.3: light detecting resistor
- 55: detection element
- 55.1: comparator
- 56: state setting element
- 56.1: switching element
- 56.2: fuse
- 57: diode
- 60: circuit carrier
- 61: wire bonding
- 90: battery module
- 91: heat exchange member
- 92: elastic member
- 100: battery system
- 101: battery system housing
- 102: negative system terminal
- 103: positive system terminal

## Claims

1. A control unit (50) for a battery module (90) or battery system (100) with a plurality of battery cells (10), the control unit (50) comprising:
a control module (53) configured for performing at least control function with respect to the at least one battery cell (10); and
an access detection circuit (52) connected to the control module (53) and comprising a light sensitive element (54) and being configured to output a light signal with a strength depending on an light incident on the light sensitive element (54) in the housing (30,101),
wherein the access detection circuit (52) is configured to output an access detection signal in response to detecting, via the light sensitive element (54), a light intensity exceeding a predefined threshold,
a state setting element (56) configured to receive the light signal or the access detection signal and to alter a state of the control module (53) in response to the received signal, wherein the state setting element (56) comprises at least one fuse configured to be set non-conductive, if the received signal exceeds a predefined threshold and wherein the light sensitive element (54) is configured to provide, in response to incident light intensity exceeding the predefined threshold, the energy for setting the at least one fuse non-conductive.

2. The control unit (50) of claim 1, further configured to alter at least one of a hardware state and a software state of the control module (53) in response to the access detection signal.

3. The control unit (50) of claim 1 or 2, further configured to store the access detection signal in a memory of the control unit (50), preferably of the control module (53).

4. The control unit (50) of any one of the preceding claims, further configured to disable at least one function of the control module (53) in response to the access detection signal.

5. The control unit (50) of claim 4, further configured to allow the enablement of the at least one function of the control module (53) by an original equipment manufacturer.

6. The control unit (50) of claim 1, further comprising a detection element (55) configured to receive the light signal, to determine whether the light intensity exceeds the predefined threshold based on the light signal, and to output the access detection signal, if the light intensity exceeds the predefined threshold.

7. The control unit (50) of claim 1, further comprising a power input (51) configured to receive an operation voltage of the control unit (50) and to provide the operation voltage to the control module (53), wherein the state setting element (56) comprises a switching element (56.1) disposed between the power input (51) and the control module (53), and wherein the state setting element (56) is configured to set the switching element (56.1) non-conductive in response to receiving the access detection signal.

8. The control unit (50) of any one of the preceding claims, wherein the light sensitive element (54) comprises at least one of a light dependent resistor (54.3), a photo diode (54.1), and a photovoltaic element.

9. Battery module (90) or battery system (100) comprising a plurality of battery cells (10) fully enclosed by a housing (30,101) and a control module (50) of one of claims 1 to 8.

10. Method for operating the battery module (90) or battery system (100) of claim 9, the method comprising the steps of:
performing, via the control module (53), at least one control function with respect to at least one battery cell (10);
detecting, via the light sensitive element (54), light intensity within the housing (30,101) fully enclosing the battery cells (10) and outputting a light signal with a strength depending on an light incident on the light sensitive element (54) in the housing (30,101);
outputting, via the access detection circuit (52), an access detection signal, if the detected light intensity exceeds a predefined threshold; and
altering a state of the control module (53) in response to the light signal or access detection signal by setting at least the one fuse of the state setting element (56) non-conductive by using energy provided by the light sensitive element (54) in response to incident light intensity exceeding the predefined threshold.

11. Method according to claim 10, further comprising the steps of:
disabling, in response to the access detection signal, at least one function of the control module (53), and
enabling, by an original equipment manufacturer, the at least one control function of the control module (53).

## Patentansprüche

1. Steuereinheit (50) für ein Batteriemodul (90) oder ein Batteriesystem (100) mit mehreren Batteriezellen (10), die Steuereinheit (50) umfassend:
ein Steuermodul (53), das so konfiguriert ist, dass es mindestens eine Steuerfunktion in Bezug auf die mindestens eine Batteriezelle (10) ausführt; und
eine Zugangserkennungsschaltung (52), die mit dem Steuermodul (53) verbunden ist und ein lichtempfindliches Element (54) umfasst und so konfiguriert ist, dass sie ein Lichtsignal mit einer Stärke ausgibt, die von einem Licht abhängt, das auf das lichtempfindliche Element (54) in dem Gehäuse (30, 101) einfällt,
wobei die Zugangserkennungsschaltung (52) so konfiguriert ist, dass sie ein Zugangserkennungssignal ausgibt, wenn sie über das lichtempfindliche Element (54) eine Lichtintensität erkennt, die einen vordefinierten Schwellenwert überschreitet,
ein Zustandseinstellelement (56), das so konfiguriert ist, dass es das Lichtsignal oder das Zugangserkennungssignal empfängt und einen Zustand des Steuermoduls (53) als Reaktion auf das empfangene Signal ändert, wobei das Zustandseinstellelement (56) mindestens eine Sicherung umfasst, die so konfiguriert ist, dass sie nicht leitend ist, wenn das empfangene Signal einen vordefinierten Schwellenwert überschreitet, und wobei das lichtempfindliche Element (54) so konfiguriert ist, dass es als Reaktion auf eine einfallende Lichtintensität, die den vordefinierten Schwellenwert überschreitet, die Energie zum Einstellen der mindestens einen Sicherung auf nicht-leitend bereitstellt.

2. Steuereinheit (50) nach Anspruch 1, ferner so konfiguriert, dass sie als Reaktion auf das Zugangserkennungssignal mindestens einen Hardwarezustand und/oder einen Softwarezustand des Steuermoduls (53) ändert.

3. Steuereinheit (50) nach Anspruch 1 oder 2, ferner so konfiguriert, dass sie das Zugangserkennungssignal in einem Speicher der Steuereinheit (50), vorzugsweise des Steuermoduls (53), speichert.

4. Steuereinheit (50) nach einem der vorhergehenden Ansprüche, ferner so konfiguriert, dass sie als Reaktion auf das Zugangserkennungssignal mindestens eine Funktion des Steuermoduls (53) deaktiviert.

5. Steuereinheit (50) nach Anspruch 4, ferner so konfiguriert, dass sie die Freigabe der mindestens einen Funktion des Steuermoduls (53) durch einen Originalgerätehersteller ermöglicht.

6. Steuereinheit (50) nach Anspruch 1, ferner umfassend ein Erfassungselement (55), das so konfiguriert ist, dass es das Lichtsignal empfängt, anhand des Lichtsignals bestimmt, ob die Lichtintensität den vordefinierten Schwellenwert überschreitet, und das Zugangserkennungssignal ausgibt, wenn die Lichtintensität den vordefinierten Schwellenwert überschreitet.

7. Steuereinheit (50) nach Anspruch 1, ferner umfassend einen Leistungseingang (51), der so konfiguriert ist, dass er eine Betriebsspannung der Steuereinheit (50) empfängt und die Betriebsspannung an das Steuermodul (53) liefert, wobei das Zustandseinstellelement (56) ein Schaltelement (56.1) umfasst, das zwischen dem Leistungseingang (51) und dem Steuermodul (53) angeordnet ist, und wobei das Zustandseinstellelement (56) so konfiguriert ist, dass es das Schaltelement (56.1) als Reaktion auf das Empfangen des Zugangserkennungssignals nicht-leitend macht.

8. Steuereinheit (50) nach einem der vorhergehenden Ansprüche, wobei das lichtempfindliche Element (54) mindestens einen von einem lichtabhängigen Widerstand (54.3), eine von einer Fotodiode (54.1) und eines von einem photovoltaischen Element umfasst.

9. Batteriemodul (90) oder Batteriesystem (100), umfassend mehrere Batteriezellen (10), die vollständig von einem Gehäuse (30, 101) umschlossen sind, und ein Steuermodul (50) nach einem der Ansprüche 1 bis 8.

10. Verfahren zum Betreiben des Batteriemoduls (90) oder Batteriesystems (100) nach Anspruch 9, wobei das Verfahren die folgenden Schritte umfasst:
Ausführen mindestens einer Steuerfunktion in Bezug auf mindestens eine Batteriezelle (10) über das Steuermodul (53) ;
Erfassen, über das lichtempfindliche Element (54), der Lichtintensität innerhalb des Gehäuses (30, 101), das die Batteriezellen (10) vollständig umschließt und Ausgeben eines Lichtsignals mit einer Stärke, die von einem auf das lichtempfindliche Element (54) in dem Gehäuse (30, 101) einfallenden Licht abhängt;
Ausgeben, über die Zugangserkennungsschaltung (52), eines Zugangserkennungssignals, wenn die erfasste Lichtintensität einen vordefinierten Schwellenwert überschreitet; und
Ändern eines Zustands des Steuermoduls (53) als Reaktion auf das Lichtsignal oder das Zugangserkennungssignal, indem mindestens die eine Sicherung des Zustandseinstellelements (56) unter Verwendung von Energie, die von dem lichtempfindlichen Element (54) als Reaktion auf eine einfallende Lichtintensität, die den vordefinierten Schwellenwert überschreitet, nicht-leitend gemacht wird.

11. Verfahren nach Anspruch 10, ferner umfassend die Schritte:
Deaktivieren mindestens einer Funktion des Steuermoduls (53) als Reaktion auf das Zugangserkennungssignal, und
Freigeben der mindestens einen Steuerfunktion des Steuermoduls (53) durch einen Originalgerätehersteller.

## Revendications

1. Unité de commande (50) pour un module de batterie (90) ou un système de batterie (100) ayant une pluralité d'éléments de batterie (10), l'unité de commande (50) comprenant :
un module de commande (53) configuré pour réaliser au moins une fonction de commande par rapport à l'au moins un élément de batterie (10) ; et
un circuit de détection d'accès (52) connecté au module de commande (53) et comprenant un élément sensible à la lumière (54) et étant configuré pour délivrer en sortie un signal lumineux ayant une intensité dépendant d'une lumière incidente sur l'élément sensible à la lumière (54) dans le boîtier (30, 101),
dans laquelle le circuit de détection d'accès (52) est configuré pour délivrer en sortie un signal de détection d'accès en réponse à la détection, via l'élément sensible à la lumière (54), d'une intensité de lumière dépassant un seuil prédéfini,
un élément de réglage d'état (56) configuré pour recevoir le signal lumineux ou le signal de détection d'accès et pour modifier un état du module de commande (53) en réponse au signal reçu, où l'élément de réglage d'état (56) comprend au moins un fusible configuré pour être réglé non conducteur, si le signal reçu dépasse un seuil prédéfini et où l'élément sensible à la lumière (54) est configuré pour fournir, en réponse à une intensité de lumière incidente dépassant le seuil prédéfini, l'énergie pour régler non conducteur l'au moins un fusible.

2. Unité de commande (50) selon la revendication 1, configurée en outre pour modifier au moins l'un parmi un état matériel et un état logiciel du module de commande (53) en réponse au signal de détection d'accès.

3. Unité de commande (50) selon la revendication 1 ou 2, configurée en outre pour stocker le signal de détection d'accès dans une mémoire de l'unité de commande (50), de préférence du module de commande (53).

4. Unité de commande (50) selon l'une quelconque des revendications précédentes, configurée en outre pour désactiver au moins une fonction du module de commande (53) en réponse au signal de détection d'accès.

5. Unité de commande (50) selon la revendication 4, configurée en outre pour permettre l'activation de l'au moins une fonction du module de commande (53) par un équipementier d'origine.

6. Unité de commande (50) selon la revendication 1, comprenant en outre un élément de détection (55) configuré pour recevoir le signal de lumière, pour déterminer si l'intensité de lumière dépasse le seuil prédéfini sur la base du signal lumineux, et pour délivrer en sortie le signal de détection d'accès, si l'intensité de lumière dépasse le seuil prédéfini.

7. Unité de commande (50) selon la revendication 1, comprenant en outre une entrée de puissance (51) configurée pour recevoir une tension de fonctionnement de l'unité de commande (50) et pour fournir la tension de fonctionnement au module de commande (53), dans laquelle l'élément de réglage d'état (56) comprend un élément de commutation (56.1) disposé entre l'entrée de puissance (51) et le module de commande (53), et dans laquelle l'élément de réglage d'état (56) est configuré pour régler non conducteur l'élément de commutation (56.1) en réponse à la réception du signal de détection d'accès.

8. Unité de commande (50) selon l'une quelconque des revendications précédentes, dans laquelle l'élément sensible à la lumière (54) comprend au moins l'un parmi une résistance dépendant de la lumière (54.3), une photodiode (54.1), et un élément photovoltaïque.

9. Module de batterie (90) ou système de batterie (100) comprenant une pluralité d'éléments de batterie (10) entièrement renfermés par un boîtier (30, 101) et un module de commande (50) selon l'une des revendications 1 à 8.

10. Procédé pour faire fonctionner le module de batterie (90) ou le système de batterie (100) selon la revendication 9, le procédé comprenant les étapes consistant à :
réaliser, via le module de commande (53), au moins une fonction de commande par rapport à au moins un élément de batterie (10) ;
détecter, via l'élément sensible à la lumière (54), une intensité de lumière à l'intérieur du boîtier (30, 101) renfermant entièrement les éléments de batterie (10) et délivrer en sortie un signal lumineux ayant une intensité dépendant d'une lumière incidente sur l'élément sensible à la lumière (54) dans le boîtier (30, 101) ;
délivrer en sortie, via le circuit de détection d'accès (52), un signal de détection d'accès, si l'intensité de lumière détectée dépasse un seuil prédéfini ; et
modifier un état du module de commande (53) en réponse au signal de lumière ou au signal de détection d'accès en réglant non conducteur au moins ledit fusible de l'élément de réglage d'état (56) en utilisant une énergie fournie par l'élément sensible à la lumière (54) en réponse à une intensité de lumière incidente dépassant le seuil prédéfini.

11. Procédé selon la revendication 10, comprenant en outre les étapes consistant à :
désactiver, en réponse au signal de détection d'accès, au moins une fonction du module de commande (53), et
activer, par un équipementier d'origine, l'au moins une fonction de commande du module de commande (53).
